# EUROPÄISCHE PATENTANMELDUNG

(11) **EP 1 473 154 A2**
(43) Veröffentlichungstag der Anmeldung: **03.11.2004**
(21) Anmeldenummer: 04005584.0
(22) Anmeldetag: 01.06.1999
(51) Int. Cl.: B41C 1/10

(54) **Druckverfahren und Druckmaschine**

(30) Priorität: 12.06.1998 DE 19826377
(62) Teilanmeldung aus: 99109362.6
(71) Anmelder: Heidelberger Druckmaschinen Aktiengesellschaft, 69115 Heidelberg (DE)
(72) Erfinder: d'Heureuse, Walter, 68526 Ladenburg (DE); Schmitt-Lewen, Martin, 69118 Heidelberg (DE); Kipphan, Helmut, Prof. Dr. Dr., 68723 Schwetzingen (DE)

(57) **Zusammenfassung**

Ein erfindungsgemäßes Druckverfahren mit den aufeinanderfolgenden Verfahrensschritten:
a) eine Druckform (2), deren Oberfläche (12) aus einem Material besteht, dessen Benetzungseigenschaften reversibel zwischen einem Zustand mit einem sehr kleinen Randwinkel und einem Zustand mit einem relativ großen Randwinkel veränderlich sind, mit Licht zu belichten, um Bildbereiche zu schaffen, b) die Druckform (2) einzufärben, wobei die Druckfarbe in den Bildbereichen von der Druckform (2) angenommen wird, c) die Druckfarbe von der Druckform (2) auf einen Bedruckstoff zu übertragen, d) die Verfahrensschritte b) und c) nach Bedarf zu wiederholen und e) die Druckform (2) zu reinigen, zeichnet sich dadurch aus, daß die Druckform (2) nur in den Bildbereichen mit Licht belichtet wird, dessen Wellenlänge kürzer als eine materialspezifische Wellenlänge ist, um die Bildbereiche in den Zustand mit einem sehr kleinen Randwinkel zu bringen.

## Beschreibung

Die Erfindung betrifft ein Druckverfahren gemäß Oberbegriff von Anspruch 1 und eine Druckmaschine gemäß Oberbegriff von Anspruch 6.

Beim Offsetdruck werden immer größere Teile der Arbeiten zur Herstellung der Druckform, der sogenannten Druckvorstufe, mit Hilfe von elektronischer Datenverarbeitung durchgeführt.

Bei der sogenannten Computer-to-plate-Technik laufen sämtliche Arbeiten von der Erstellung des Seitenlayouts bis zur digital angesteuerten Bebilderung der Druckplatte im Computer ab. Die Bebilderung der Druckplatten findet getrennt in einer speziellen Belichtungseinheit statt. Bei der sogenannten Computer-to-press/Direct Imaging-Technik, wie sie die Heidelberger Druckmaschinen AG erstmalig in der GTO-DI angewendet hat, ist die Belichtungseinheit in die Druckmaschine verlagert. Die Platten werden direkt in der Druckmaschine auf dem Zylinder belichtet.

Hinsichtlich Digitaldruck noch weitergehende Techniken, auch Computer-to-print und Computer-to-paper genannt, bestehen darin, digitalisierte Daten aus einem Computer ohne Druckform mit festem Bild über einen Zwischenträger (z.B. Fotoleiter) oder ohne jede materielle Zwischenstufe auf Papier oder andere Bedruckstoffe zu übertragen. Entsprechende Drucktechniken sind z.B. Elektrofotografie, Thermotransferdruck oder Tintenstrahldruck und erlauben es, das Motiv während des laufenden Drucks zu wechseln, z.B. mit jeder Umdrehung eines Formzylinders ein neues Druckbild zu erzeugen. Hierbei entfällt die Herstellung einer Druckform, da jedes einzelne Druckbild neu geschrieben wird. Damit verzichtet man jedoch auf den Vorteil konventioneller Verfahren wie z.B. Offsetdruck, von einer konstanten Druckform mit hoher Produktivität drucken zu können und über die Auflage eine sehr hohe Qualität zu gewährleisten.

Aus Dokument EP-A-0911154, welches Stand der Technik nach Art. 54(3) und (4) EPÜ bildet, ist bereits eine Vorrichtung sowie ein Verfahren zum Bebildern wiederbeschreibbarer Druckplatten bekannt. Dabei wird eine Druckplatte zunächst durch vollflächige UV-Bestrahlung in einen hydrophilen Zustand und anschließend lokal in den Bildbereichen mit IR-Bestrahlung in einen lipophilen Zustand versetzt. In einem darauffolgenden Schritt wird in konventioneller Weise Druckfarbe und Feuchtmittel auf die zuvor bebilderte Oberfläche der Druckplatte aufgebracht.

Auch aus Dokument EP-A-0911155, welches ebenfalls Stand der Technik nach Art. 54(3) und (4) EPÜ bildet, ist bereits eine Vorrichtung sowie ein Verfahren zum Bebildern wiederbeschreibbarer Druckplatten bekannt. Dabei wird eine Druckplatte zunächst durch Wärmebehandlung, z. B. durch IR-Bestrahlung, vollflächig in einen lipophilen Zustand und anschließend lokal in den Nicht-Bildbereichen mit UV-Bestrahlung in einen hydrophilen Zustand versetzt. In einem darauffolgenden Schritt wird in konventioneller Weise Druckfarbe und Feuchtmittel auf die zuvor bebilderte Oberfläche der Druckplatte aufgebracht.

Der Erfindung liegt die Aufgabe zugrunde, eine Druckmaschine und korrespondierende Druckverfahren zu schaffen, mit denen es möglich ist, sowohl kontinuierlich von einem Master zu drucken, wie es beim Offsetdruck geschieht, als auch das Motiv während des laufenden Drucks zu ändern, wie es z.B. bei Elektrofotografie möglich ist.

Ein erfindungsgemäßes Druckverfahren mit den aufeinanderfolgenden Verfahrensschritten:
a) eine Druckform, deren Oberfläche aus einem Material besteht, dessen Benetzungseigenschaften reversibel zwischen einem Zustand mit einem sehr kleinen Randwinkel und einem Zustand mit einem relativ großen Randwinkel veränderlich sind, mit Licht zu belichten, um Bildbereiche zu schaffen,
b) die Druckform einzufärben, wobei die Druckfarbe in den Bildbereichen von der Druckform angenommen wird,
c) die Druckfarbe von der Druckform auf einen Bedruckstoff zu übertragen,
d) die Verfahrensschritte b) und c) nach Bedarf zu wiederholen und
e) die Druckform zu reinigen,
zeichnet sich dadurch aus,
dass die Druckform nur in den Bildbereichen mit Licht belichtet wird, dessen Wellenlänge kürzer als eine materialspezifische Wellenlänge ist, um die Bildbereiche in den Zustand mit einem sehr kleinen Randwinkel zu bringen.

Der Randwinkel ist definiert als der Winkel, den die Oberfläche einer an die Druckformoberfläche angrenzenden Flüssigkeit mit der Druckformoberfläche bildet, und ist ein Maß für die Grenzflächenspannung zwischen der Druckformoberfläche und der Flüssigkeit.

Bei dem erfindungsgemäßen Verfahren wird ein Positivbild des Druckbildes auf der Druckform hergestellt.

Es kann gemäß einer Ausführungsform der Erfindung vorgesehen sein, daß die Druckfarbe unmittelbar von der Druckform auf einen Bedruckstoff übertragen wird, oder daß die Druckfarbe über einen Zwischenträger von der Druckform auf einen Bedruckstoff übertragen wird.

Mit der Erfindung kann die Druckfarbe über einen Zwischenträger von der Druckform auf einen Bedruckstoff übertragen werden, z. B. über einen Gummizylinder wie bei konventionellem Offsetdruck. In diesem Fall muß bei einem Wechsel des Druckmotivs nicht nur die Druckform, sondern auch der Zwischenträger gereinigt werden. Die Reinigung eines Zwischenträgers entfällt, wenn die Druckfarbe ähnlich wie im Tiefdruck direkt von der Druckform auf einen Bedruckstoff übertragen wird.

Es kann gemäß einer weiteren Ausführungsform der Erfindung vorgesehen sein, daß nach Wahl entweder kontinuierlich mit einem von Druck zu Druck gleichen Motiv oder variabel mit einem von Druck zu Druck verschiedenen Motiv gedruckt wird.

Es kann gemäß einer weiteren Ausführungsform der Erfindung vorgesehen sein, daß die Druckform in den Bildbereichen UV-belichtet wird.

Es kann gemäß einer weiteren Ausführungsform der Erfindung vorgesehen sein, daß die belichteten Stellen eingefärbt werden, bevor sich Wasser aus der Umgebungsluft daran anlagern kann.

Ausgehend von einer Druckmaschine für die Computer-to-press/Direct Imaging-Technik, die eine Druckform, eine optische Bebilderungseinheit zur Direktbebilderung der Druckform und ein Farbwerk zur Einfärbung der Druckform enthält, wird die Aufgabe der vorliegenden Erfindung durch Schaffung einer Druckmaschine erfindungsgemäß wie folgt gelöst.

Eine erfindungsgemäße Druckmaschine mit
- einer Druckform, deren Oberfläche aus einem Material besteht, dessen Benetzungseigenschaften reversibel zwischen einem Zustand mit einem sehr kleinen Randwinkel und einem Zustand mit einem relativ großen Randwinkel veränderlich sind,
- einer optischen Bebilderungseinheit zur Direktbebilderung der Druckform, wobei Bildbereiche geschaffen werden,
- einem Farbwerk zum Einfärben der Bildbereichen der Druckform, und
- einer Reinigungseinrichtung zur Reinigung der Oberfläche der Druckform, zeichnet sich dadurch aus,
daß die Bebilderungseinheit Licht aussendet, dessen Wellenlänge kürzer als eine materialspezifische Wellenlänge ist, um die Bildbereiche in den Zustand mit einem sehr kleinen Randwinkel zu bringen und daß das von der Bebilderungseinheit ausgesandte Licht ein Positivbild des Druckbildes darstellt.

Ein Material mit den genannten Eigenschaften existiert z.B. in Form von TiO₂, vgl. die Zeitschrift Nature, Vol. 388, 31. Juli 1997, S. 431. TiO₂-Oberflächen werden unter ultravioletter Strahlung amphiphil, d.h. sowohl hydrophil als auch oleophil. Insbesondere ändert sich z.B. der Randwinkel von Wasser an der Oberfläche von normalerweise 72° auf im wesentlichen 0° bei Belichtung; die veränderte Oberflächeneigenschaft ist reversibel.

Es kann gemäß einer Ausführungsform der Erfindung vorgesehen sein, daß das Material Ti02 enthält.

Mit diesem oder einem Material mit ähnlichen Eigenschaften wird die Druckform beschichtet, die häufig ein Formzylinder ist, aber auch eine Druckplatte sein kann.

Die Bebilderungseinheit kann z.B. ein steuerbarer Infrarotlaser mit einer Strahlablenkeinheit oder eine LED-Zeile mit Infrarot-Leuchtdioden sein, der bzw. die die Druckform bildpunktweise bzw. zeilenweise beschreibt. Derartige Bebilderungseinheiten gibt es z.B. für elektrofotographische Drucker.

Laser-Bebilderungseinheiten für ultraviolettes Licht sind sehr kostspielig, und entsprechende LED-Bebilderungseinheiten stehen zur Zeit noch nicht serienmäßig zur Verfügung. Jedoch kann man z.B. eine herkömmliche UV-Quelle verwenden, die einen gebündelten Strahl erzeugt, der wie ein Laserstrahl abgelenkt und moduliert wird, um ein Bild auf die Druckform zu schreiben. Weitere Möglichkeiten sind, die Druckform durch eine Maske hindurch mit ultraviolettem Licht zu bestrahlen oder ein Array von schaltbaren Spiegeln zu verwenden.

Es kann gemäß einer weiteren Ausführungsform der Erfindung vorgesehen sein, daß die Druckform ein Formzylinder, eine Platte oder ein Band ist.

Es kann gemäß einer weiteren Ausführungsform der Erfindung vorgesehen sein, daß die vom Farbwerk auf die Druckform aufgebrachte Farbe eine Offsetfarbe oder eine offsetähnliche Farbe ist.

Abhängig von der speziellen Beschaffenheit der Oberfläche der Druckform und von dem verwendeten Druckverfahren kann die Druckfarbe möglicherweise eine konventionelle oder eine geeignet modifizierte Offsetfarbe sein.

Die heutigen Offsetfarben für wasserlosen Offsetdruck enthalten Silikonöl. Beim Farbauftrag auf die Silikonoberfläche der Druckform bildet sich ein feiner Silikonölfilm, der die Farbannahme in den druckfreien Bereichen verhindert. In Analogie dazu kann eine wasserbasierende Farbe entwickelt werden, die im Zusammenspiel mit der molekularen Wasserschicht auf der Druckform ebenfalls eine abstoßende Wirkung zeigt. Daher sind die für die Erfindung in Betracht kommenden Druckfarben nicht auf ölbasierende Farben beschränkt.

Es kann gemäß einer weiteren Ausführungsform der Erfindung vorgesehen sein, daß die Bebilderungseinheit eine UV-Bebilderungseinheit ist.

Es kann gemäß einer weiteren Ausführungsform der Erfindung vorgesehen sein, daß die Bebilderungseinheit möglichst nahe vor dem Farbwerk angeordnet ist, derart, dass die belichteten Stellen eingefärbt werden, bevor sich Wasser aus der Umgebungsluft anlagern kann.

Es kann gemäß einer weiteren Ausführungsform der Erfindung vorgesehen sein, daß eine Baugruppe aus der Bebilderungseinheit und einer Farbwalze des Farbwerks von der Umgebungsluft abgeschirmt ist, derart, dass die belichteten Stellen eingefärbt werden, bevor sich Wasser aus der Umgebungsluft anlagern kann.

Wie erwähnt, ist bei der Druckmaschine und dem Druckverfahren der Erfindung das Druckbild wegen der besonderen Eigenschaften der Oberfläche der Druckform selbsterhaltend. Daher muß das Druckbild nicht für jeden einzelnen Druckvorgang neu aufgebracht werden. Nachdem die gewünschte Anzahl Drucke hergestellt worden ist, kann die Zylinderoberfläche mit einem geeigneten Reinigungsmittel gereinigt werden. Zur Durchführung der Verfahren zwei, drei und vier kann ein Reinigungsmittel von Vorteil sein, das auf chemischem und/oder physikalischem Wege den Zustand mit relativ großem Randwinkel wiederherstellt. Bei dem ersten Verfahren ist dies nicht notwendig, da die Oberfläche durch die Flächenbelichtungseinheit vollständig amphiphil gemacht wird, bevor ein neues Druckbild geschrieben wird.

Die erwähnten TiO₂-Oberflächen wurden im Hinblick darauf entwickelt, das Beschlagen von Fensterscheiben zu verhindern sowie eine Selbstreinigung von Oberflächen in Außenbereichen zu erreichen. Für diese Anwendungen sind lange Standzeiten von Vorteil. Für die Erfindung ist es jedoch von Vorteil, wenn das Druckbild möglichst schnell geändert werden kann, bis hin zu dem Fall, daß z.B. bei jeder Umdrehung eines Formzylinders ein neues Druckbild geschrieben werden kann.

Wenn es daher im Falle des Verfahrens nicht möglich oder mit zu hohem Aufwand verbunden ist, die amphiphile Eigenschaft der Druckformoberfläche z.B. mit Hilfe der Reinigungseinrichtung gezielt zurückzubilden, sollte die Standzeit eher kurz sein, damit die amphiphile Eigenschaft der Druckformoberfläche schnell von selbst abklingen kann und sofort ein neues Druckbild geschrieben werden kann. Bei einer TiO₂-Oberfläche läßt sich dies möglicherweise durch Änderungen der chemischen Zusammensetzung oder durch physikalische Strukturänderungen erreichen, oder man findet weitere Stoffe, die ähnliche oder für die Anwendung bei Druckmaschinen noch günstigere Eigenschaften haben.

Falls die Standzeit der amphiphilen Eigenschaft der Druckformoberfläche bis auf ungefähr 0,1 bis 1 Sekunde herabgesetzt werden kann, kann z.B. bei jeder Umdrehung eines Formzylinders ein neues Druckbild geschrieben werden. Da das Druckbild in diesem Fall nur eine sehr kurze Zeit erhalten bleibt, müßte es nicht nur im Falle von Einzelmotivdruck, sondern auch im Falle von Auflagendruck fortlaufend erneuert werden. In Übereinstimmung mit der Erfindung sind die Vorteile des Offsetdrucks weiter vorhanden.

Die optimale Standzeit hängt vom jeweiligen Anwendungszweck der Druckmaschine ab. Je nachdem, in welchem Umfang Auflagendruck und in welchem Umfang Einzelmotivdruck gewünscht ist, wird man möglicherweise einen Kompromiß eingehen.

Die gewünschten Eigenschaften der Druckformoberfläche lassen sich durch geeignete Wahl der Kristallform des Oberflächenmaterials und gegebenenfalls durch Zugabe von weiteren Materialen (z.B. Dotierung mit geeigneten Fremdatomen) bei der Herstellung erzielen bzw. für den vorliegenden Anwendungszweck optimieren. Als Basismaterial kommen auch andere Materialien als Titanoxid in Betracht, z.B. Hafniumoxid oder Oxide von anderen Elementen der vierten Nebengruppe (Titangruppe) des Periodensystems der Elemente.

Die atomaren Vorgänge bei der lichtinduzierten Ausbildung der amphiphilen Eigenschaft des Materials der Druckformoberfläche lassen darauf schließen, daß sich ein für den vorliegenden Anwendungszweck geeignetes Material oder Materialgemisch finden läßt, das nicht nur durch entsprechende Belichtung amphiphil gemacht werden kann, sondern dessen amphiphile Eigenschaft gezielt wieder nach hydrophob und oleophob zurückgebildet werden kann.

Im Falle von Titanoxid muß die Aktivierungsschwelle überwunden werden, oberhalb derer die bei UV-Belichtung erzeugten Sauerstoff-Fehlstellen unter Sauerstoffangebot wieder besetzt werden. Um die Aktivierungsschwelle zu überwinden, könnte die Oberfläche der Druckform mit einer weiteren Strahlungsquelle belichtet werden, die beispielsweise genügend intensives IR-Licht aussendet. Übrigens könnte eine flächenmäßige Belichtung der Druckform mit einer solchen Strahlungsquelle z.B. in der Reinigungseinrichtung ausgenutzt werden, um die Druckform vor der Neubebilderung flächig in den nicht amphiphilen Zustand zu versetzen.

Wie erwähnt, ermöglicht es die Erfindung, sowohl kontinuierlich von einem Master zu drucken, wobei das Motiv von Druck zu Druck gleich bleibt, als auch variabel zu drucken, wobei das Motiv von Druck zu Druck geändert wird, und man kann zu jeder Zeit von einem dieser Verfahren auf das andere wechseln.

Nachstehend wird die Erfindung anhand von Ausführungsbeispielen unter Bezugnahme auf die Zeichnung näher erläutert. In der Zeichnung zeigt:

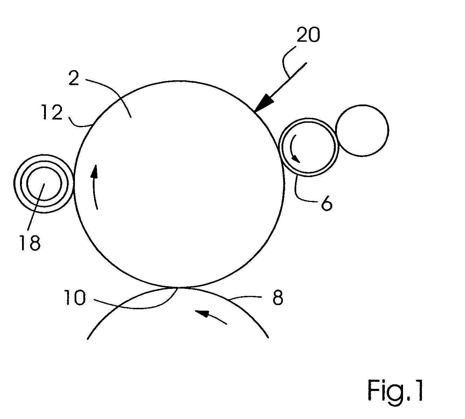

- Fig. 1: eine erfindungsgemäße Druckmaschine mit einem wiederbeschreibbaren Formzylinder zur Durchführung des erfindungsgemäßen Druckverfahrens.

Die gezeigte Druckmaschine weist eine UV-Bebilderungseinheit 20 auf, welche möglichst nahe vor dem Farbwerk angeordnet ist.

Um mit der gezeigten Druckmaschine zu drucken, wird der Formzylinder 2 bildmäßig positiv (d.h. in Bildbereichen) UV-belichtet. Die belichteten Stellen werden eingefärbt, bevor sich Wasser aus der Umgebungsluft daran anlagern kann. Gegebenenfalls kann die Baugruppe aus der UV-Bebilderungseinheit 20 und der Farbwalze 6 von der Umgebungsluft abgeschirmt werden. Fortdruck und Motivwechsel erfolgen so wie weiter unten beschrieben.

Der Formzylinder 2 weist eine Oberfläche 12 aus einem Material auf, das die Eigenschaft hat, zwei verschiedene Zustände annehmen zu können, einen ersten Zustand, in dem eine an die Oberfläche 12 angrenzende Flüssigkeit einen relativ großen Randwinkel bildet, z.B. 72° für Wasser, und einen zweiten Zustand mit einem sehr kleinen Randwinkel von nahezu 0°. Eine solche Oberfläche 12 ist z.B. eine Keramik aus Titanoxid (TiO₂ oder aus modifiziertem Titanoxid. Der erste Zustand stellt sich mit der Zeit automatisch ein, wenn sich die Oberfläche 12 in einer dunklen und trockenen Umgebung befindet, und ausgehend von diesem Zustand wird der zweite Zustand durch Einwirkung von ultravioletter Strahlung erreicht. In dem zweiten Zustand ist die Oberfläche 12 extrem amphiphil, d.h. sowohl hydrophil als auch oleophil. Wasser oder Öl, das damit in Kontakt kommt, spreitet sich zu einem extrem dünnen Film.

Das Farbwerk enthält eine Farbwalze 6, die auf der Oberfläche 12 des Formzylinders 2 abrollt und über weitere Walzen und nicht gezeigte Farbversorgungen gleichmäßig mit Druckfarbe versorgt wird, um den Formzylinder 2 in Übereinstimmung mit dem Druckbild einzufärben.

Die Übertragungsstation enthält einen Zylinder 8 in Form eines Gummizylinders oder eines anderen Zwischenträgers, auf den das auf dem Formzylinder 2 gebildete Druckbild aus Druckfarbe an einer linienförmigen Berührungsstelle 10 zwischen dem Formzylinder 2 und dem Zylinder 8 übertragen wird. An einer anderen, nicht gezeigten Stelle am Umfang des Zylinders 8 wird das Druckbild weiter auf einen Bedruckstoff übertragen, z.B. auf eine Weise, wie sie aus dem Offsetdruck bekannt ist. Alternativ kann der Bedruckstoff zwischen dem Formzylinder 2 und dem Zylinder 8 hindurchgeführt werden, d.h. wie z.B. im Tiefdruck direkt bedruckt werden. In diesem Fall stellt der Zylinder 8 einen Gegendruckzylinder dar.

Die Reinigungsstation enthält eine schematisch dargestellte Reinigungseinrichtung 18, die wahlweise aktivierbar ist, um die Oberfläche 12 des Formzylinders 2 von übriggebliebener Druckfarbe zu reinigen.

Beim Farbübertrag auf den Zylinder 8 oder direkt z.B. auf Papier spaltet sich die Farbe, wie es aus dem Offsetdruck bekannt ist. Dadurch bleibt Restfarbe bildmäßig auf der Oberfläche 12 des Formzylinders 2 erhalten. Wenn die Oberfläche 12 des Formzylinders 2 die Farbwalze 6 das nächste Mal passiert, wird die Farbe daher ergänzt, ohne daß vorher neu bebildert werden muß. Somit können viele Druckvorgänge schnell aufeinanderfolgend durchgeführt werden. Während dessen kann die UV-Flächenbelichtungseinheit ausgeschaltet bleiben.

Soll das Druckbild geändert werden, so tritt die Reinigungseinrichtung 18 in Aktion, um die Oberfläche 12 des Formzylinders 2 von Restfarbe zu reinigen.

Falls nicht abgewartet werden kann, daß sich der Zustand der Oberfläche 12 mit einem relativ großem Randwinkel von selbst wieder einstellt, kann die Reinigungseinrichtung 18 zusätzlich auf eine solche Weise chemisch und/oder physikalisch auf die Oberfläche 12 einwirken, daß die Rückkehr in den Ursprungszustand beschleunigt wird. Alternativ kann von vornherein für eine kurze Standzeit der amphiphilen Eigenschaft der Oberfläche 12 des Formzylinders 2 gesorgt werden, z.B. 0,1 bis 1 Sekunde, bei der sich die amphiphile Eigenschaft gerade während eines Umlaufs des Formzylinders 2 von selbst verliert, so daß er unmittelbar neu beschrieben werden kann. In jedem Fall muß die Oberfläche 12 des Formzylinders 2 völlig trocken sein, bevor sie neu beschrieben werden kann.

### Bezugszeichenliste

- 2: Formzylinder/Druckform
- 6: Farbwalze
- 8: Zylinder
- 10: Berührungsstelle
- 12: Oberfläche
- 18: Reinigungseinrichtung
- 20: UV-Bebilderungseinheit

## Patentansprüche

1. Druckverfahren mit den aufeinanderfolgenden Verfahrensschritten:
a) eine Druckform (2), deren Oberfläche (12) aus einem Material besteht, dessen Benetzungseigenschaften reversibel zwischen einem Zustand mit einem sehr kleinen Randwinkel und einem Zustand mit einem relativ großen Randwinkel veränderlich sind, mit Licht zu belichten, um Bildbereiche zu schaffen,
b) die Druckform einzufärben, wobei die Druckfarbe in den Bildbereichen von der Druckform angenommen wird,
c) die Druckfarbe von der Druckform auf einen Bedruckstoff zu übertragen,
d) die Verfahrensschritte b) und c) nach Bedarf zu wiederholen und
e) die Druckform zu reinigen,
**dadurch gekennzeichnet,**
**daß** die Druckform (2) nur in den Bildbereichen mit Licht belichtet wird, dessen Wellenlänge kürzer als eine materialspezifische Wellenlänge ist, um die Bildbereiche in den Zustand mit einem sehr kleinen Randwinkel zu bringen.

2. Verfahren nach Anspruch 1,
**dadurch gekennzeichnet,**
**daß** die Druckfarbe unmittelbar von der Druckform (2) auf einen Bedruckstoff übertragen wird, oder daß die Druckfarbe über einen Zwischenträger (8) von der Druckform (2) auf einen Bedruckstoff übertragen wird.

3. Verfahren nach einem der vorhergehenden Ansprüche,
**dadurch gekennzeichnet,**
**daß** nach Wahl entweder kontinuierlich mit einem von Druck zu Druck gleichen Motiv oder variabel mit einem von Druck zu Druck verschiedenen Motiv gedruckt wird.

4. Verfahren nach einem der vorhergehenden Ansprüche,
**dadurch gekennzeichnet,**
**daß** die Druckform (2) in den Bildbereichen UV-belichtet wird.

5. Verfahren nach einem der vorhergehenden Ansprüche,
**dadurch gekennzeichnet,**
**daß** die belichteten Stellen eingefärbt werden, bevor sich Wasser aus der Umgebungsluft daran anlagern kann.

6. Druckmaschine mit
- einer Druckform (2), deren Oberfläche (12) aus einem Material besteht, dessen Benetzungseigenschaften reversibel zwischen einem Zustand mit einem sehr kleinen Randwinkel und einem Zustand mit einem relativ großen Randwinkel veränderlich sind,
- einer optischen Bebilderungseinheit (20) zur Direktbebilderung der Druckform (2), wobei Bildbereiche geschaffen werden,
- einem Farbwerk (6) zum Einfärben der Bildbereichen der Druckform (2), und
- einer Reinigungseinrichtung (18) zur Reinigung der Oberfläche der Druckform (2),
**dadurch gekennzeichnet,**
**daß** die Bebilderungseinheit (20) Licht aussendet, dessen Wellenlänge kürzer als eine materialspezifische Wellenlänge ist, um die Bildbereiche in den Zustand mit einem sehr kleinen Randwinkel zu bringen und daß das von der Bebilderungseinheit (20) ausgesandte Licht ein Positivbild des Druckbildes darstellt.

7. Druckmaschine nach Anspruch 6,
**dadurch gekennzeichnet,**
**daß** das Material TiO2 enthält.

8. Druckmaschine nach einem der Ansprüche 6 bis 7,
**dadurch gekennzeichnet,**
**daß** die Druckform (2) ein Formzylinder (2), eine Platte oder ein Band ist.

9. Druckmaschine nach einem der Ansprüche 6 bis 8,
**dadurch gekennzeichnet,**
**daß** die vom Farbwerk (6) auf die Druckform (2) aufgebrachte Farbe eine Offsetfarbe oder eine offsetähnliche Farbe ist.

10. Druckmaschine nach einem der Ansprüche 6 bis 9,
**dadurch gekennzeichnet,**
**daß** die Bebilderungseinheit (20) eine UV-Bebilderungseinheit (20) ist.

11. Druckmaschine nach einem der Ansprüche 6 bis 10,
**dadurch gekennzeichnet,**
**daß** die Bebilderungseinheit (20) möglichst nahe vor dem Farbwerk (6) angeordnet ist, derart, dass die belichteten Stellen eingefärbt werden, bevor sich Wasser aus der Umgebungsluft anlagern kann.

12. Druckmaschine nach einem der Ansprüche 6 bis 11,
**dadurch gekennzeichnet,**
**daß** eine Baugruppe aus der Bebilderungseinheit (20) und einer Farbwalze (6) des Farbwerks (6) von der Umgebungsluft abgeschirmt ist, derart, dass die belichteten Stellen eingefärbt werden, bevor sich Wasser aus der Umgebungsluft anlagern kann.
